# FASCICULE DE BREVET EUROPEEN

(11) **EP 3 732 725 B1**
(45) Date de publication et mention de la délivrance du brevet: **09.03.2022**
(21) Numéro de dépôt: 18842799.1
(22) Date de dépôt: 21.12.2018
(51) Int. Cl.: H01L 27/15, H01L 33/18, H01L 33/20, H01L 33/42, H01L 33/62, H01L 33/24, H01L 33/32, H01L 33/44, H01L 33/50, H01L 33/60

(54) **DISPOSITIF OPTOÉLECTRONIQUE À MATRICE DE DIODES TRIDIMENSIONNELLES**
OPTOELEKTRONISCHE VORRICHTUNG MIT EINER MATRIX AUS DREIDIMENSIONALEN DIODEN
OPTOELECTRONIC DEVICE WITH MATRIX OF THREE-DIMENSIONAL DIODES

(30) Priorité: 27.12.2017 FR 1763244
(43) Date de publication de la demande: 04.11.2020
(73) Titulaire: Aledia, 38040 Grenoble (FR)
(72) Inventeur: BEIX, Vincent, 38600 Fontaine (FR); DORNEL, Erwan, 38800 Champagnier (FR)
(74) Mandataire: INNOV-GROUP
(86) Numéro de dépôt international: PCT/FR2018/053513
(87) Numéro de publication internationale: WO 2019/129978

(56) Documents cités:
- WO-A1-2017/042512
- WO-A1-2018/002498
- US-A- 4 868 614
- US-A1- 2015 279 903
- US-A1- 2015 280 053

## Description

### DOMAINE TECHNIQUE

Le domaine de l'invention est celui des dispositifs optoélectroniques à matrice de diodes tridimensionnelles, par exemple du type filaire ou pyramidal. L'invention s'applique au domaine des dispositifs à matrice de diodes électroluminescentes tels que les dispositifs d'éclairage, les écrans d'affichage et les projecteurs d'images, ainsi qu'au domaine des dispositifs à matrice de photodiodes tels que les photodétecteurs et les capteurs.

### ÉTAT DE LA TECHNIQUE ANTÉRIEURE

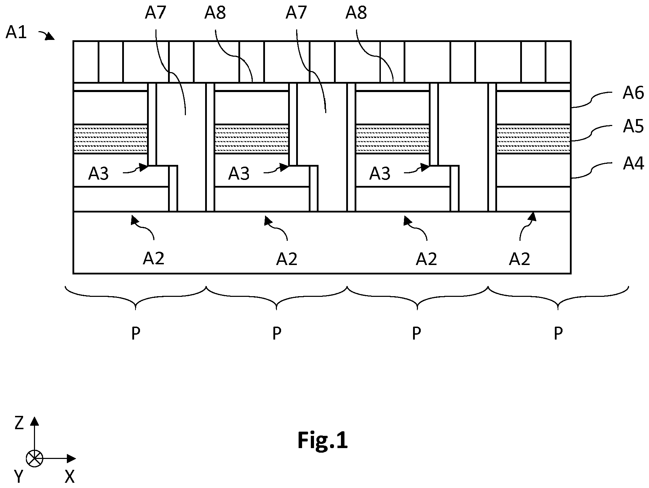

Il existe des dispositifs optoélectroniques à matrice de diodes électroluminescentes adaptées à former des dispositifs d'éclairage, des écrans d'affichage et des projecteurs d'images. Le document EP 2 960 940 A1 illustre un exemple de dispositif optoélectronique à matrice de diodes électroluminescentes. Comme l'illustre de manière schématique la figure 1, ce dispositif optoélectronique A1 comporte une pluralité de diodes électroluminescentes A2 comportant chacune un empilement d'une portion A6 dopée p et d'une portion A4 dopée n séparées l'une de l'autre par une zone active A5 d'où est majoritairement généré le rayonnement lumineux de la diode A2.

Les diodes électroluminescentes A2 présentent une structure dite mesa, c'est-à-dire qu'elles sont obtenues à partir d'un empilement de couches semiconductrices destinées à former les portions dopées A4, A6 ainsi que la zone active A5, une gravure localisée étant effectuée de manière à individualiser les diodes électroluminescentes A2 les unes des autres. Chaque diode A2 comporte une forme en L dont les flancs sont revêtus d'une couche isolante, hormis au niveau d'un décrochement A3 que forme la portion dopée A4. Des premières électrodes A8 reposent sur la surface supérieure des portions dopées A6 et des deuxièmes électrodes A7 s'étendent entre les diodes A2 et viennent au contact des décrochements A3 formés par les portions dopées A4. Un pixel d'affichage comporte alors l'empilement des portions dopées A4, A6, de la zone active A5, et de la première électrode A8, ainsi que la deuxième électrode A7 adjacente à l'empilement. Une structure de connexion est assemblée à la face supérieure de la matrice de diodes électroluminescentes et est destinée à être hybridée à un circuit intégré de commande.

Ce dispositif optoélectronique comporte cependant l'inconvénient de nécessiter une étape de gravure des couches semiconductrices dopées et de la couche active pour individualiser les diodes. Or cette étape de gravure peut d'entraîner la formation de défauts structuraux susceptibles de dégrader les propriétés optiques et/ou électroniques des diodes. De plus, le rapport entre la surface émissive de chaque diode sur la surface de chaque pixel est réduite par la nécessité de former un décrochement dans la portion dopée n et par la présence de la deuxième électrode A7 qui s'étend entre les diodes de manière à venir au contact de ce décrochement. Cela réduit ainsi l'intensité lumineuse maximale relative à chaque pixel.

Les documents WO 2017/042512 A1, US 2015/0280053 A1, US 2015/0279903 A1 et US 4 868 614 A décrivent d'autres dispositifs optoélectroniques selon l'art antérieur.

### EXPOSÉ DE L'INVENTION

L'invention a pour objectif de remédier au moins en partie aux inconvénients de l'art antérieur, et plus particulièrement de proposer un dispositif optoélectronique à matrice de diodes tridimensionnelles formant des pixels pouvant être activés indépendamment les uns des autres. Un autre objectif est de proposer un dispositif optoélectronique dont la conduction électrique des porteurs de charges dans des premières électrodes électriquement connectées aux pieds des diodes tridimensionnelles est améliorée.

Pour cela, l'objet de l'invention est un dispositif optoélectronique, comportant :
- un support ;
- une pluralité de premières électrodes distinctes, s'étendant longitudinalement au contact du support, parallèlement à un axe A1, chaque première électrode étant formée d'un empilement d'une portion conductrice longitudinale située au contact du support et revêtue d'une bande conductrice de nucléation, la portion conductrice longitudinale présentant une résistance électrique inférieure de celle de la bande conductrice de nucléation ;
- une pluralité de diodes comportant chacune une première portion tridimensionnelle dopée selon un premier type de conductivité et une deuxième portion dopée selon un deuxième type de conductivité opposé au premier type, les premières portions dopées étant au contact des bandes conductrices de nucléation, agencées de sorte que chaque bande conductrice de nucléation est au contact de plusieurs premières portions dopées disposées longitudinalement ;
- au moins une couche isolante intermédiaire recouvrant les premières électrodes ;
- une pluralité de deuxièmes électrodes distinctes, sous forme de bandes conductrices transparentes, s'étendant longitudinalement au contact des deuxièmes portions dopées, électriquement isolées des premières électrodes au moyen de la couche isolante intermédiaire, parallèlement à un axe A2, l'axe A2 étant non parallèle à l'axe A1, de sorte qu'une même bande conductrice transparente est au contact de secondes portions dopées d'un ensemble de diodes dont les premières portions dopées sont au contact de différentes bandes conductrices de nucléation.

Certains aspects préférés mais non limitatifs de ce dispositif optoélectronique sont les suivants.

Les portions conductrices longitudinales peuvent présenter une épaisseur prédéterminée et être réalisées en un matériau semiconducteur dopé selon le premier type de conductivité, le niveau de dopage et l'épaisseur étant adaptés de sorte qu'un rapport résistivité électrique sur épaisseur des portions conductrices longitudinales est inférieur à celui des bandes conductrices de nucléation.

Les premières électrodes peuvent être isolées transversalement les unes des autres par des tranchées d'isolation.

Chaque première électrode peut reposer sur une couche isolante inférieure et présenter des flancs latéraux qui s'étendent jusqu'à la couche isolante inférieure, la couche isolante intermédiaire s'étendant de manière à recouvrir les bandes conductrices de nucléation ainsi que les flancs latéraux.

Les bandes conductrices transparentes peuvent s'étendre de manière à recouvrir les bandes conductrices de nucléation, les flancs latéraux et la couche isolante inférieure, et être électriquement isolées des flancs latéraux par la couche isolante intermédiaire.

Chaque tranchée d'isolation peut être comblée, c'est-à-dire remplie, par un matériau isolant formant avec les bandes conductrices de nucléation une surface plane.

Les tranchées d'isolation peuvent présenter une largeur comprise entre 0,15µm et 10µm.

Le support peut comporter une couche semiconductrice dopée selon le deuxième type de conductivité, les portions conductrices longitudinales étant formés dans la couche semiconductrice dopée sous la forme de caissons longitudinaux distincts les uns des autres dopés selon le premier type de conductivité.

La couche isolante intermédiaire peut s'étendre de manière plane et recouvrir les premières électrodes en étant au contact des bandes conductrices de nucléation.

Chaque bande conductrice transparente peut comporter des parties recouvrant un ensemble de deuxièmes portions dopées, lesdites parties recouvrantes étant reliées entre elles par des parties de liaison reposant sur la couche isolante intermédiaire.

Les parties de liaison peuvent être recouvertes par et au contact d'une couche conductrice réfléchissante.

Le matériau des bandes conductrices de nucléation peut comporter un métal de transition.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1, déjà décrite, est une vue en coupe, schématique et partielle, d'un exemple de dispositif optoélectronique à matrice de pixels lumineux comportant des diodes électroluminescentes de type mesa ;
la figure 2 est une vue de dessus, schématique et partielle, d'un exemple de dispositif optoélectronique selon un mode de réalisation dans lequel les diodes sont au contact de bandes conductrices de nucléation et de bandes conductrices transparentes formant une matrice de pixels ;
les figures 3A et 3B sont des vues en coupe, schématiques et partielles, respectivement suivant les plans de coupe A-A et B-B illustrés sur la fig.2, d'un dispositif optoélectronique selon un premier mode de réalisation dans lequel les bandes conductrices transparentes s'étendent dans les tranchées d'isolation électrique ;
les figures 4A à 4F sont des vues en coupe, suivant les plans de coupe A-A et B-B, de différentes étapes d'un procédé de fabrication du dispositif optoélectronique illustré sur les fig.3A et 3B ;
les figures 5A et 5B sont des vues en coupe, schématiques et partielles, respectivement suivant les plans de coupe A-A et B-B illustrés sur la fig.2, d'un dispositif optoélectronique selon un deuxième mode de réalisation dans lequel les tranchées d'isolation électrique sont comblées de manière à former une surface plane continue ;
les figures 6A à 6F sont des vues en coupe, suivant les plans de coupe A-A et B-B, de différentes étapes d'un procédé de fabrication du dispositif optoélectronique illustré sur les fig.5A et 5B ;
la figure 7A illustre des vues en coupe, schématiques et partielles, respectivement suivant les plans de coupe A-A et B-B illustrés sur la fig.2, d'un dispositif optoélectronique selon un troisième mode de réalisation dans lequel les portions conductrices longitudinales sont formées par dopage localisé du support ; et la figure 7B illustre des vues en coupe, schématiques et partielles, respectivement suivant les plans de coupe A-A et B-B, d'un dispositif optoélectronique selon une variante du troisième mode de réalisation.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près. Par ailleurs, l'expression « comportant un » doit être comprise comme « comportant au moins un », sauf indication contraire.

L'invention porte sur un dispositif optoélectronique comportant une matrice de diodes tridimensionnelles pixélisées, c'est-à-dire que les diodes sont agencées en différents pixels pouvant être activés indépendamment les uns des autres. Les diodes présentent une forme tridimensionnelle et comporte chacune une première portion dopée tridimensionnelle et une deuxième portion dopée. La forme tridimensionnelle des diodes peut être telle que les diodes présentent une forme de fils, de plot, de pyramide ou autre. Les diodes peuvent être des diodes électroluminescentes adaptées à émettre un rayonnement lumineux, voire des photodiodes adaptées à recevoir un rayonnement lumineux. Ainsi, les pixels peuvent être des pixels lumineux ou des pixels de photodétection. Dans la suite de la description, les diodes sont des diodes électroluminescentes.

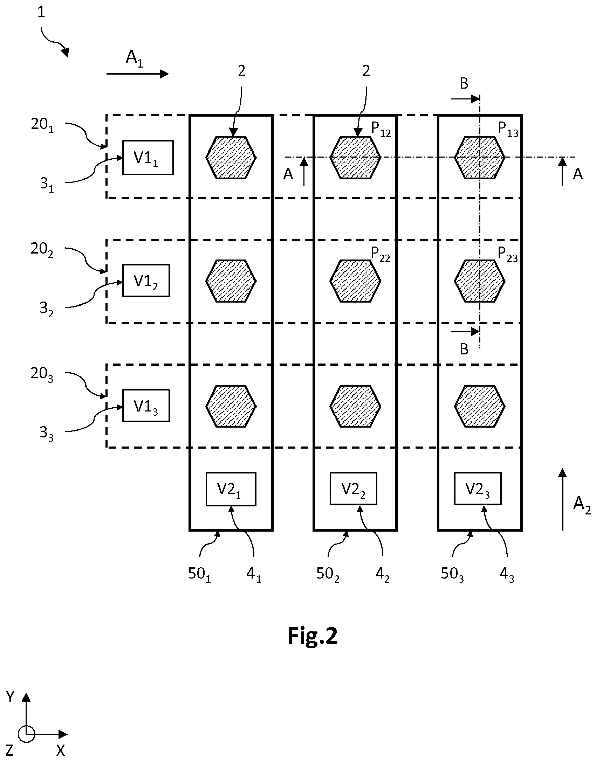

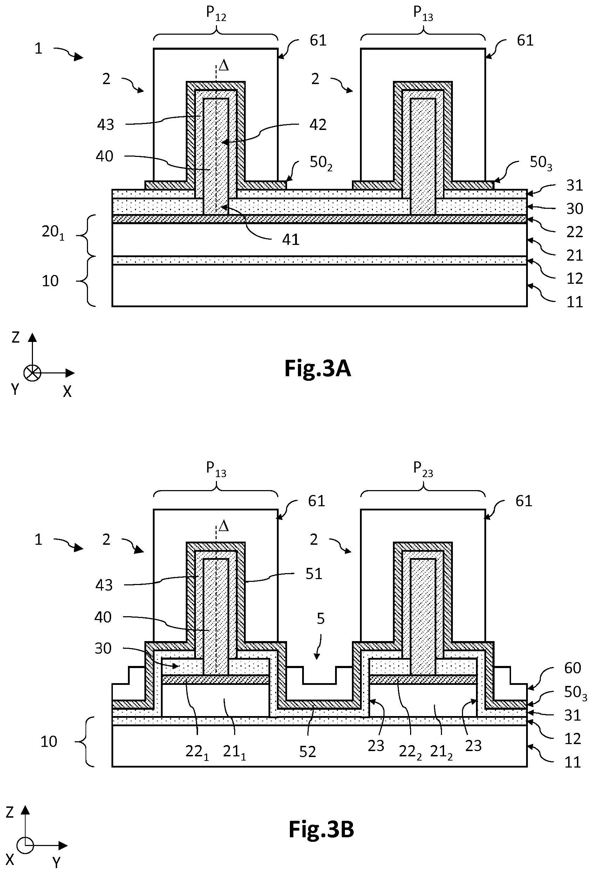

La figure 2 et les figures 3A et 3B illustrent un premier mode de réalisation d'un dispositif optoélectronique 1 à matrice de pixels comportant chacun une ou plusieurs diodes 2 électroluminescentes. La fig.2 est une vue schématique et partielle de dessus, et les fig.3A et 3B sont des vues schématiques et partielles en coupe, respectivement, selon le plan A-A et B-B.

On définit ici et pour la suite de la description un repère direct tridimensionnel XYZ, où les axes X et Y forment un plan parallèle au plan principal du substrat, et où l'axe Z est orienté de manière sensiblement orthogonale à la face avant du substrat. Par ailleurs, les termes « inférieur » et « supérieur » s'entendent comme étant relatifs à un positionnement croissant lorsqu'on s'éloigne de la face avant du substrat suivant la direction +Z.

D'une manière générale, le dispositif optoélectronique 1 comporte :
- un support 10 ;
- une pluralité de premières électrodes 20 distinctes, s'étendant longitudinalement de manière parallèle à un axe A1, chaque première électrode 20 étant formée d'un empilement d'une portion conductrice longitudinale 21 de faible résistance électrique revêtue d'une bande conductrice de nucléation 22 de plus forte résistance électrique ;
- une pluralité de diodes 2 tridimensionnelles, comportant chacune une première portion dopée 40 tridimensionnelle et une deuxième portion dopée 43, les premières portions dopées 40 étant au contact des bandes conductrices de nucléation 22 ;
- au moins une couche isolante intermédiaire 30, 31 recouvrant les premières électrodes 20;
- une pluralité de deuxièmes électrodes 50 se présentant sous la forme de bandes conductrices transparentes distinctes, s'étendant chacune au contact de différents ensembles de deuxièmes portions dopées 43 des diodes 2 de manière parallèle à un axe A2 non parallèle à l'axe A1.

Le support 10 comporte deux faces, dites arrière et avant, opposées l'une à l'autre. La face avant est celle sur laquelle reposent les diodes 2. Il peut être formé d'un empilement de couches, par exemple une couche semiconductrice revêtue d'une couche électriquement isolante, et peut ainsi être un substrat de type SOI (pour *Silicon On Insulator,* en anglais) dans lequel une couche mince semiconductrice revêt la couche isolante Il peut, en variante, être un substrat monobloc réalisé en un matériau électriquement isolant, par exemple du saphir, ou en un matériau semiconducteur voire conducteur. Dans cet exemple, le support 10 est formé d'une couche épaisse 11 revêtue d'une couche isolante inférieure 12. La face supérieure de la couche isolante inférieure 12 définit la face avant électriquement isolante du support 10. Autrement dit, le substrat comporte une couche électriquement isolante, ici la couche isolante inférieure 12, sur laquelle reposent les portions conductrices longitudinales.

La couche épaisse 11 peut présenter une épaisseur comprise entre 50nm et 1500µm, selon qu'il a été aminci ou non. Dans cet exemple où le support 10 a été aminci dans le but par exemple de permettre une reprise de contact électrique en face arrière, voire de limiter l'encombrement, d'augmenter la flexibilité, et/ou de réduire la résistance thermique, il peut présenter une épaisseur par exemple comprise entre 10µm et 300µm, de préférence comprise entre 10µm et 100µm. Dans le cas où il n'a pas été aminci, notamment lorsque la reprise de contact est assurée en face avant, il peut présenter une épaisseur comprise entre 300µm et 1500µm, par exemple égale à 725µm environ.

La couche isolante inférieure 12 est destinée à assurer une isolation électrique entre les portions conductrices longitudinales 21 et la couche épaisse 11 lorsque celle-ci est électriquement conductrice. Le matériau de la couche isolante inférieure 12 peut être un oxyde de silicium (par exemple SiO2) ou d'aluminium (par exemple Al2O3), un nitrure de silicium SiNx ou d'aluminium AlN, un oxynitrure de silicium SiOxNy, ou tout autre matériau adapté. L'épaisseur de la couche isolante inférieure 12 peut être comprise entre 5nm et 50µm, de préférence comprise entre 10nm et 500nm, par exemple égale à 30nm environ. Dans cet exemple, le matériau de la couche épaisse 11 est du silicium monocristallin et le matériau de la couche isolante inférieure 12 est du SiO2. En variante, la couche isolante inférieure 12 peut être formée en un matériau semiconducteur, par exemple en silicium, mais présentant un type de conductivité et/ou une polarité opposés à ceux des portions conductrices longitudinales 21, de manière à assurer une isolation électrique par jonction pn polarisée en inverse (déplétion).

Le dispositif optoélectronique 1 comporte des premières électrodes 20 de polarisation permettant l'application d'un potentiel électrique V1ᵢ aux premières portions dopées 40 des diodes 2. Le potentiel électrique V1ᵢ peut varier dans le temps, et peut être différent d'une première électrode 20 à l'autre. Chaque première électrode 20 se présente sous la forme d'une bande conductrice qui s'étend longitudinalement sur le support 10 de manière parallèle à un axe A1. Elles peuvent s'étendre longitudinalement dans le plan XY de manière rectiligne ou courbe, parallèlement les unes aux autres. Par bande conductrice, on entend ici une étendue d'au moins un matériau électriquement conducteur, par exemple semiconducteur ou métallique, déposé en couche mince, qui présente une dimension longitudinale dans le plan XY (longueur) supérieure à la dimension transversale dans le plan XY (largeur) et à la dimension d'épaisseur suivant l'axe Z. Les premières électrodes 20 sont distinctes les unes des autres, dans le sens où elles sont physiquement séparées et électriquement isolées les unes des autres. Chaque première électrode 20 est formée d'un empilement d'une portion conductrice longitudinale 21, située au contact du support 10, revêtue au niveau d'une face supérieure par une bande conductrice de nucléation 22.

Les portions conductrices longitudinales 21 sont destinées à améliorer la conduction électrique des porteurs de charges entre les premiers plots de connexion 3 et les premières portions dopées 40 des diodes 2, au travers des bandes conductrices de nucléation 22. Pour cela, elles présentent une résistance électrique inférieure à celle des bandes conductrices de nucléation 22. Autrement dit, le rapport de la résistivité électrique du matériau des portions conductrices longitudinales 21 sur la surface transversale (produit de l'épaisseur et de la largeur) est inférieur à celui des bandes conductrices de nucléation 22.

Elles s'étendent longitudinalement sur le support 10, et sont revêtues chacune, avec contact électrique, par une bande conductrice de nucléation 22. Elles sont de plus électriquement reliées à des premiers plots de connexion 3 adaptés à appliquer le potentiel électrique V1ᵢ aux portions conductrices longitudinales 21 et donc aux bandes conductrices de nucléation 22.

Elles sont distinctes les unes des autres dans le sens où elles sont physiquement séparées et électriquement isolées entre elles. Pour cela, elles sont électriquement isolées de la couche épaisse 11 par la couche isolante inférieure 12 sur laquelle elles reposent, et sont isolées latéralement par des tranchées d'isolation 5. Chaque portion conductrice longitudinale 21 forme une nervure qui s'étend longitudinalement de manière parallèle à l'axe A1. Par nervure, on entend une bande en saillie par rapport au plan du support 10.

Elles sont réalisées en un matériau électriquement conducteur, de préférence en un matériau semiconducteur dopé. Le matériau présente une résistance électrique inférieure à celle des bandes conductrices de nucléation 22. Il peut ainsi être réalisé en un élément ou un composé de la colonne IV du tableau périodique, par exemple en silicium, en germanium ou en carbure de silicium, en un composé III-V, par exemple en GaN ou en GaAs, ou en un composé II-VI, par exemple en ZnO. Il peut également être réalisé en un matériau métallique. De préférence, le matériau est en silicium monocristallin. Le matériau semiconducteur est avantageusement dopé selon le même type de conductivité que celui des premières portions dopées 40 des diodes 2, de manière à diminuer sa résistivité électrique et améliorer ainsi la conduction des porteurs de charge. Le niveau de dopage peut être tel que la résistivité électrique est inférieure ou égale à quelques mΩ.cm. A titre d'exemple, le niveau de dopage des portions conductrices longitudinales 21 en silicium est de préférence supérieur à 5.10¹⁶ at/cm³, voire supérieur à 3.10¹⁷ at/cm³, et peut être inférieur à 2.10²⁰ at/cm³. Il peut ainsi être compris entre 3.10¹⁷ at/cm³ et 5.10¹⁹ at/cm³. Les dopants, dans le cas du silicium, peuvent être du bore ou de l'indium dans le cas d'un dopage de type p, ou du phosphore, de l'arsenic ou de l'antimoine dans le cas d'un dopage de type n.

Les dimensions d'épaisseur et de largeur des portions conductrices longitudinales 21 sont de préférence homogènes suivant l'axe longitudinal et égales d'une portion à l'autre. Elles sont choisies en fonction de la résistivité électrique du matériau pour que la résistance électrique des portions conductrices longitudinales 21 soit inférieure à celle des bandes conductrices de nucléation 22. L'épaisseur peut être comprise entre 0,1µm et 10µm, de préférence comprise entre 0,5µm et 5µm, par exemple égale à 1µm. La largeur peut être comprise entre 20nm et 50µm, de préférence comprise entre 0,5µm et 5µm, par exemple égale à 1µm environ. Les portions conductrices longitudinales 21 peuvent être espacées transversalement les unes des autres d'une distance par exemple comprise entre 0,3µm et 50µm, par exemple de l'ordre de 5µm à 10µm.

Les bandes conductrices de nucléation 22 reposent chacune sur et au contact de la face supérieure d'une portion conductrice longitudinale 21. Chaque bande conductrice de nucléation 22 présente une face supérieure, opposée à la face avant du support 10, qui forme une surface de nucléation sur laquelle chaque première portion dopée 40 des diodes 2 est en contact. Les bandes conductrices de nucléation 22 sont distinctes, c'est-à-dire physiquement séparées et électriquement isolées les unes des autres. Chaque bande conductrice de nucléation 22 d'indice i est au contact de plusieurs premières portions dopées 40 de diodes 2 disposées longitudinalement, l'ensemble des diodes 2 étant noté Dᵢ.

Les bandes conductrices de nucléation 22 sont réalisées en un matériau électriquement conducteur adapté à la nucléation et la croissance des premières portions dopées 40. Ce matériau peut être du nitrure de gallium GaN, ou un alliage à base de nitrure de gallium, par exemple du nitrure de gallium et d'aluminium AlGaN, du nitrure de gallium et d'indium InGaN, voire du nitrure de gallium, d'aluminium et d'indium AlInGaN. Les bandes conductrices de nucléation 22 sont de préférence en un matériau comportant un métal de transition. Il peut être choisi parmi le titane, le vanadium, le chrome, le zirconium, le niobium, le molybdène, le hafnium, le tantale et le tungstène, ou en un nitrure ou un carbure de métal de transition, par exemple de titane, de zirconium, de hafnium, de vanadium, de niobium, de tantale, de chrome, de molybdène, ou en une combinaison de ces composés. Les métaux de transition, ainsi que leurs nitrures et carbures, présentent les avantages de permettre la nucléation des premières portions dopées 40 et d'avoir une conductivité électrique proche de celle des métaux. Chaque bande conductrice de nucléation 22 peut être formée d'une unique portion de couche réalisée en un même matériau. Elle peut en variante être formée d'un empilement de plusieurs sous-couches, dont une sous-couche supérieure réalisée en un matériau de nucléation, par exemple à base d'un métal de transition épitaxié, et d'une sous-couche inférieure réalisée en un matériau de résistivité électrique plus élevée, par exemple en AIN cristallin texturé, comme le décrit la demande de brevet FR 3 053 054 A1 publiée le 29 décembre 2017.

Les bandes conductrices de nucléation 22 présentent une épaisseur par exemple comprise entre 5nm et 500nm, de préférence comprise entre 10nm et 100nm, par exemple égale à 30nm environ. Elles présentent une largeur de préférence égale, voire inférieure à celle des portions conductrices longitudinales 21 sous-jacentes. La résistance électrique des bandes conductrices de nucléation 22 est supérieure à celle des portions conductrices longitudinales 21. Ainsi, la présence de ces dernières permet d'améliorer la conduction électrique entre les premiers plots de connexion 3 et les premières portions dopées 40 des diodes 2. A titre d'exemple, et en première approximation, dans le cas où les portions conductrices longitudinales 21 présentent une épaisseur de 1µm et les bandes conductrices de nucléation 22 une épaisseur de 20nm, la résistivité électrique et la largeur étant identiques, la résistance électrique de la première électrode 20 est 50 fois plus petite avec les portions conductrices longitudinales 21 qu'en absence des portions conductrices longitudinales 21.

Chaque première électrode 20 présente, dans ce premier mode de réalisation, une structure conductrice en saillie par rapport au plan du support 10. Chaque structure en saille est distincte de ses voisines, c'est-à-dire physiquement séparée et électriquement isolée, par des tranchées d'isolation 5. Les tranchées d'isolation 5 forment des échancrures qui s'étendent longitudinalement entre deux premières électrodes 20 adjacentes, suivant l'axe A1. Les structures conductrices en saillie présentent ici une face supérieure définie par la face supérieure des bandes conductrices de nucléation 22 et des flancs latéraux 23 qui s'étendent de la face supérieure jusqu'à la couche isolante inférieure 12.

Le dispositif optoélectronique 1 comporte en outre une première couche isolante intermédiaire 30 qui recouvre les bandes conductrices de nucléation 22. Elle forme un masque de croissance autorisant la croissance épitaxiale des premières portions dopées 40 des diodes 2 à partir d'ouvertures traversantes 30.1 débouchant localement sur les surfaces de nucléation. Elle participe également à assurer l'isolation électrique entre les premières électrodes 20 et les deuxièmes électrodes 50, et plus précisément entre les bandes conductrices de nucléation 22 et les bandes conductrices transparentes 50. La première couche isolante intermédiaire 30 est réalisée en un ou plusieurs matériaux diélectriques tels que, par exemple, un oxyde de silicium (par exemple SiO2) ou un nitrure de silicium (par exemple Si₃N₄ ou SiN), voire un oxynitrure de silicium, un oxyde d'aluminium (par exemple Al2O3) ou un oxyde de hafnium (par exemple HfO2). L'épaisseur de la couche isolante intermédiaire peut être comprise entre 5nm et 1µm, de préférence comprise entre 30nm et 500nm, par exemple égale à 100nm environ. Dans cet exemple, la première couche isolante intermédiaire 30 s'étend uniquement sur la face supérieure des bandes conductrices de nucléation 22. En variante, elle peut s'étendre également sur les flancs latéraux 23 des premières électrodes 20.

Chaque diode 2 électroluminescente comporte une première portion dopée 40, de forme tridimensionnelle. Dans ce mode de réalisation, les premières portions dopées 40 présentent une forme allongée suivant un axe longitudinal Δ, c'est-à-dire dont la dimension longitudinale suivant l'axe longitudinal Δ est supérieure aux dimensions transversales. Les premières portions dopées 40 sont alors appelées « fils », « nanofils » ou « microfils ». Les dimensions transversales des fils, c'est-à-dire leurs dimensions dans un plan orthogonal à l'axe longitudinal Δ, peuvent être comprises entre 10nm et 10µm, par exemple comprises entre 100nm et 10µm, et de préférence comprises entre 100 nm et 5µm. La hauteur des fils, c'est-à-dire leur dimension longitudinale suivant l'axe longitudinal Δ, est supérieure aux dimensions transversales, par exemple 2 fois, 5 fois et de préférence au moins 10 fois supérieure. La section droite des fils, dans un plan orthogonal à l'axe longitudinal Δ, peut présenter différentes formes, par exemple une forme circulaire, ovale, polygonale par exemple triangulaire, carrée, rectangulaire voire hexagonale. On définit ici le diamètre comme étant une grandeur associée au périmètre du fil au niveau d'une section droite. Il peut s'agir du diamètre d'un disque présentant la même surface que la section droite du fil. Le diamètre local est le diamètre du fil à une hauteur donnée de celui-ci suivant l'axe longitudinal Δ. Le diamètre moyen est la moyenne, par exemple arithmétique, des diamètres locaux le long du fil ou d'une portion de celui-ci.

Chaque première portion dopée 40 s'étend à partir de la surface de nucléation d'une bande conductrice de nucléation 22, suivant un axe longitudinal Δ orienté de manière sensiblement orthogonale au plan XY. Chaque diode 2 comporte en outre une zone active et une seconde portion dopée 43. Le fil forme ici le cœur d'une diode 2 électroluminescente en configuration cœur/coquille, la zone active et la seconde portion dopée recouvrant la bordure latérale d'une partie dite supérieure du fil. Les fils comportent une partie inférieure 41 qui est au contact des surfaces de nucléation et est entourée par la couche isolante intermédiaire 30. Cette partie inférieure 41 se prolonge par la partie supérieure 42 qui est située hors des ouvertures 30.1 de croissance et est recouverte par la zone active et la seconde portion dopée 43.

Les fils 40 peuvent être réalisés en un matériau cristallin épitaxié à partir de la surface de nucléation. Le matériau des fils 40 comporte majoritairement un premier composé semiconducteur qui peut être choisi parmi les composés III-V et en particulier parmi les composés III-N, parmi les composés II-VI ou parmi les composés ou éléments IV. A titre d'exemple, des composés III-V peuvent être des composés tels que GaN, InGaN, AlGaN, AlN, InN ou AlInGaN, voire des composés tels que l'AsGa ou l'InP. Des composés II-VI peuvent être CdTe, HgTe, CdHgTe, ZnO, ZnMgO, CdZnO, CdZnMgO. Des éléments ou composés IV peuvent être Si, C, Ge, SiC, SiGe, GeC. Les fils 40 forment ainsi les premières portions dopées 40 des diodes 2, et sont dopés selon un premier type de conductivité, ici de type n. Dans cet exemple, les fils 40 sont en GaN dopé de type n, notamment par du silicium. Ils présentent ici un diamètre moyen compris entre 10nm et 10µm, par exemple compris entre 500nm et 5µm et est ici sensiblement égal à 500nm. La hauteur des fils 9 peut être comprise entre 100nm et 100µm, par exemple comprise entre 500nm et 50µm, et est ici sensiblement égale à 5µm.

La zone active est la portion de la diode 2 au niveau de laquelle est émis l'essentiel du rayonnement lumineux de la diode 2. Elle peut comprendre au moins un puits quantique réalisé en un composé semiconducteur présentant une énergie de bande interdite inférieure à celles de la première portion dopée 40 et de la seconde portion dopée 43. Elle recouvre ici la bordure supérieure et la bordure latérale de la première portion dopée 40. Elle peut comporter un unique puits quantique ou une pluralité de puits quantiques sous forme de couches ou de boîtes intercalées entre des couches barrières. De manière alternative, la zone active peut ne pas comporter de puits quantique. Elle peut présenter une énergie de bande interdite sensiblement égale à celle de la première portion dopée 40 et de la seconde portion dopée 43. Elle peut être réalisée en un composé semiconducteur non intentionnellement dopé.

La seconde portion dopée 43 forme une couche qui recouvre et entoure au moins en partie la zone active. Elle est réalisée en un second composé semiconducteur dopé selon un second type de conductivité opposé au premier type, c'est-à-dire ici de type p. Le second composé semiconducteur peut être identique au premier composé semiconducteur de la première portion dopée 40 ou peut comporter le premier composé semiconducteur et en outre un ou plusieurs éléments supplémentaires. Dans cet exemple, la seconde portion dopée 43 peut être du GaN ou de l'InGaN, dopé de type p notamment par du magnésium. L'épaisseur de la seconde portion dopée 43 peut être comprise entre 20nm et 500nm, et peut être égale à 150nm environ. Bien entendu, les types de conductivité des première et seconde portions dopées 40, 43 peuvent être inversés. La seconde portion dopée 43 peut comporter en outre une couche intercalaire de blocage d'électrons (non représentée) située à l'interface avec la zone active. La couche de blocage d'électrons peut ici être formée d'un composé ternaire III-N, par exemple de l'AlGaN ou de l'AlInN, avantageusement dopé p. Elle permet d'accroître le taux de recombinaisons radiatives dans la zone active.

Le dispositif optoélectronique 1 comporte en outre une deuxième couche isolante intermédiaire 31 qui recouvre les premières électrodes 20 et participe à assurer l'isolation électrique entre les premières électrodes 20 et les deuxièmes électrodes 50. La deuxième couche isolante recouvre, dans cet exemple, les flancs latéraux 23 des premières électrodes 20, c'est-à-dire ceux des bandes conductrices de nucléation 22 et des portions conductrices longitudinales 21. Elle peut recouvrir également le masque de croissance 30, ainsi que la couche isolante inférieure 12, comme illustré sur la fig.3A et 3B. Elle peut venir au contact d'une partie inférieure des deuxièmes portions dopées 43. La deuxième couche isolante intermédiaire 31 peut être réalisée en un matériau diélectrique identique ou différent de celui du masque de croissance 30, tel que, par exemple, un oxyde de silicium (par exemple SiO2) ou un nitrure de silicium (par exemple Si3N4 ou SiN), voire un oxynitrure de silicium, un oxyde d'aluminium (par exemple Al2O3) ou un oxyde de hafnium (par exemple HfO2). L'épaisseur de la deuxième couche isolante intermédiaire 31 peut être comprise entre 5nm et 1µm, de préférence comprise entre 30nm et 500nm, par exemple égale à 100nm environ.

Les deuxièmes électrodes 50 de polarisation sont agencées de manière à permettre l'application d'un deuxième potentiel électrique V2ⱼ à différents ensembles de diodes 2. Elles peuvent présenter un potentiel électrique V2ⱼ qui varie dans le temps, dont la valeur peut être différente d'une bande à l'autre.

Elles prennent la forme d'une pluralité de bandes conductrices transparentes 50 qui sont chacune au contact de plusieurs deuxièmes portions dopées 43 de diodes 2. Elles sont dites transparentes dans la mesure où elles sont réalisées en un matériau transparent au rayonnement lumineux émis par les diodes 2 électroluminescentes. Par transparent, on entend un matériau dont la transmission du rayonnement lumineux d'intérêt est supérieure à 50%. Elles sont distinctes les unes des autres dans le sens où elles sont physiquement séparées et électriquement isolées les unes des autres. Elles sont également électriquement isolées des premières électrodes 20 au moyen d'au moins la deuxième couche isolante intermédiaire 31.

Elles peuvent s'étendre longitudinalement dans le plan XY de manière rectiligne ou courbe, parallèlement les unes aux autres et à l'axe A2 non parallèle à l'axe A1.Dans ce mode de réalisation, chaque bande conductrice transparente 50 s'étend longitudinalement et comporte des parties 51 recouvrant les secondes portions dopées desdites diodes 2, ces parties 51 étant reliées entre elles par des parties 52 dites de liaison qui s'étendent, dans cet exemple, dans les tranchées d'isolation 5, c'est-à-dire sur les flancs latéraux 23 des premières électrodes 20 ainsi que sur le fond des tranchées d'isolation 5.

La pixellisation des diodes 2 est assurée par le fait que l'axe A1 et l'axe A2 sont non parallèles, de sorte qu'une même bande conductrice transparente 50 est au contact de secondes portions dopées d'un ensemble de diodes 2 pour lequel les premières portions dopées 40 sont au contact de différentes bandes conductrices de nucléation 22. Les axes A1 et A2 peuvent être orthogonaux. Autrement dit, chaque bande conductrice de nucléation 22 d'indice i est au contact des premières portions dopées 40 d'un ensemble Di de plusieurs diodes 2 dont les deuxièmes portions dopées 43 sont au contact de différentes bandes conductrices transparentes 50. Inversement, chaque bande conductrice transparente 50 d'indice j est au contact des deuxièmes portions dopées 43 d'un ensemble Dⱼ de diodes 2 dont les premières portions dopées 40 sont au contact de différentes bandes conductrices de nucléation 22. Ainsi, des pixels Pᵢⱼ sont définis qui correspondent à la ou les diodes 2 dont les premières portions dopées 40 sont au contact de la bande conductrice de nucléation 22 d'indice i et les deuxièmes portions dopées 43 sont au contact des bandes conductrices transparentes 50 d'indice j. Autrement dit, « l'intersection » d'une bande conductrice de nucléation 22 d'indice i avec une bande conductrice transparente 50 d'indice j forme un pixel Pᵢⱼ. Dans cet exemple illustré sur la fig.2, chaque pixel Pᵢⱼ comporte une unique diode 2, mais il peut comporter en variante une pluralité de diodes 2. Chaque pixel Pᵢⱼ peut être activé indépendamment les uns des autres.

Les bandes conductrices transparentes 50 sont réalisées en un matériau électriquement conducteur et transparent au rayonnement lumineux émis par les diodes 2. Il peut s'agir, par exemple, d'un oxyde d'indium étain (ITO, pour *Indium Tin Oxide* en anglais) ou d'un oxyde de zinc dopé au gallium (GZO, pour *Gallium doped Zinc Oxide* en anglais), voire dopé à l'aluminium ou à l'indium. Les bandes conductrices transparentes 50 présentent une épaisseur par exemple comprise entre 5nm et 500nm, de préférence comprise entre 10nm et 100nm, par exemple égale à 50nm environ. Elles présentent une largeur, par exemple comprise entre 100nm et 100µm, de préférence comprise entre 200nm et 50µm, de préférence comprise entre 800nm et 30µm, par exemple égale à 10µm environ. Les bandes conductrices transparentes 50 sont espacées transversalement les unes des autres d'une distance par exemple comprise entre 1µm et 50µm, de préférence entre 1µm et 20µm, par exemple égale à 5µm.

Dans cet exemple, une couche conductrice réfléchissante 60 est présente entre les diodes 2 et repose ici dans les tranchées d'isolation 5. La couche réfléchissante 60 peut venir combler partiellement ou entièrement le volume des tranchées d'isolation 5. Elle est réalisée en un matériau adapté à réfléchir le rayonnement lumineux incident émis par les diodes 2 en direction de l'extérieur du dispositif optoélectronique 1. Le matériau peut être un métal, par exemple de l'aluminium, de l'argent, de l'or, du cuivre, ou une combinaison de ceux-ci, ou tout autre matériau adapté, de manière à améliorer la conduction électrique dans les bandes conductrices transparentes 50. La couche réfléchissante 60 présente une épaisseur par exemple comprise entre 10nm et 2µm, de préférence comprise entre 100nm et 1µm, par exemple égale à 500nm environ.

Des plots 61 de conversion de couleur peuvent recouvrir les diodes 2, à raison de préférence d'un plot de conversion 61 par pixel. Chaque plot de conversion 61 peut être formé d'une matrice liante comportant des particules d'un matériau photoluminescent tel que le grenat d'yttrium et d'aluminium (YAG, pour *Yttrium Aluminium Garnet,* en anglais) activé par l'ion cérium YAG:Ce. Les plots de conversion 61 peuvent être adaptés à convertir au moins en partie la lumière d'excitation émise par les diodes 2 en une lumière de luminescence de différentes longueurs d'onde en fonction des plots, par exemple en une lumière verte (495nm-560nm environ), ou en une lumière rouge (600nm-650nm environ). Pour cela, le matériau photoluminescent se présente de préférence sous la forme de boîtes quantiques, c'est-à-dire sous la forme de nanocristaux semiconducteurs dont la taille moyenne peut être comprise entre 0,2nm et 1000nm, et de préférence entre 1nm et 30nm. Le matériau semiconducteur des nanocristaux peut être notamment choisi parmi le séléniure de cadmium (CdSe), le phosphore d'indium (InP), le sulfure de cadmium (CdS), le sulfure de zinc (ZnS), l'oxyde de cadmium (CdO), le séléniure de zinc et de cadmium (CdZnSe), ou parmi d'autres matériaux semiconducteurs pouvant convenir. La matrice liante peut être de la silice. L'épaisseur des plots de conversion 61 est telle qu'ils recouvrent les diodes 2, notamment à leur sommet.

En variante, une couche d'encapsulation peut recouvrir continûment les diodes 2. Elle est réalisée en un matériau diélectrique au moins partiellement transparent au rayonnement lumineux émis parles diodes 2, et peut être, par exemple, un oxyde de silicium (par exemple SiO2) ou d'aluminium (par exemple Al2O3), un nitrure de silicium SiNx ou d'aluminium AlN, un oxynitrure de silicium SiOxNy, ou tout autre matériau adapté. L'épaisseur de la couche d'encapsulation est telle qu'elle recouvre les diodes 2, notamment à leur sommet. Elle est comprise, par exemple, entre 500nm et 50µm.

Comme représenté sur la figure 2, le dispositif optoélectronique 1 comporte également une pluralité de premiers plots de connexion 3 chacun étant électriquement relié à une première électrode 20, c'est-à-dire à une portion conductrice longitudinale 21 et à une bande conductrice de nucléation 22. Les premiers plots de connexion 3 peuvent être situés en face avant ou en face arrière du support 10. Dans le cas d'une connexion électrique en face arrière du support 10, des premiers orifices traversants peuvent s'étendre entre les faces avant et arrière du support 10 et débouchent chacun sur une portion conductrice longitudinale 21. Les orifices traversants sont remplis d'un matériau conducteur et sont en contact, d'une part avec le matériau de la portion conductrice longitudinale 21 et d'autre part avec un premier plot de connexion 3. Dans le but d'isoler, le cas échéant, le matériau du substrat, les flancs des orifices traversants sont revêtus d'une couche isolante. Le matériau de remplissage et celui des premiers plots de connexion 3 peuvent être en cuivre, or, aluminium ou en tout autre matériau conducteur adapté.

Comme représenté sur la figure 2, le dispositif optoélectronique 1 comporte également une pluralité de deuxièmes plots de connexion 4 chacun étant électriquement relié à une deuxième électrode 50, c'est-à-dire à une bande conductrice transparente 50. Les deuxièmes plots de connexion 4 peuvent être situés en face avant ou en face arrière du support 10, de manière similaire ou identique à celle décrite pour les premiers plots de connexion 3.

Le dispositif optoélectronique 1 comporte un circuit intégré de commande (non représenté) assemblé au support 10, et raccordé électriquement aux premières électrodes 20 par l'intermédiaire des premiers plots de connexion 3, et aux deuxièmes électrodes 50 par l'intermédiaire des deuxièmes plots de connexion 4. Le circuit intégré de commande peut comporter des composants électroniques, par exemple des transistors, de manière à commander l'application d'une différence de potentiel électrique, de manière simultanée ou séquentielle, aux différents pixels Pᵢⱼ de diodes 2.

En fonctionnement, lorsqu'un premier potentiel électrique V1ᵢ est appliqué à la première électrode 20 (empilement d'une portion conductrice longitudinale 21 et d'une bande conductrice de nucléation 22) de rang i et un deuxième potentiel électrique est appliqué à la deuxième électrode 50 (bande conductrice transparente) de rang j, la ou les diodes 2 situées dans le pixel Pᵢⱼ sont activées et émettent un rayonnement lumineux. Les diodes 2 situées dans les autres pixels restent désactivées. Ainsi, l'émission contrôlée de chaque pixel, de manière simultanée ou séquentielle, est effectuée en polarisant l'une ou l'autre des premières électrodes 20 et l'une ou l'autre des deuxièmes électrodes 50.

Ainsi, le dispositif optoélectronique 1 comporte une pluralité de diodes 2 réparties en une matrice de pixels Pᵢⱼ activables les uns indépendamment des autres aux moyens des premières et deuxièmes électrodes 50 de polarisation qui se présentent sous la forme de bandes conductrices distinctes les unes des autres et situées en face avant du support 10. De plus, le fait que les premières électrodes 20 de polarisation présentent une fonction supplémentaire de surface de nucléation, par le biais des bandes conductrices de nucléation 22, permet de simplifier la structure ainsi que le procédé de réalisation. Par ailleurs, le fait que les premières électrodes 20 soient formées de portions conductrices longitudinales 21 de moindre résistance électrique que les bandes conductrices de nucléation 22 permet d'améliorer la conduction électrique des porteurs de charge entre les premiers plots de connexion 3 et les pieds de fils. Chaque pixel peut en outre comporter une surface développée de la zone active sensiblement égale ou supérieure à la surface du pixel dans le plan XY, de sorte que l'intensité maximale d'émission lumineuse du dispositif optoélectronique 1 peut être supérieure à celle du dispositif optoélectronique de l'art antérieur mentionné précédemment. On obtient ainsi un dispositif optoélectronique 1 à haute intensité lumineuse et à haute résolution.

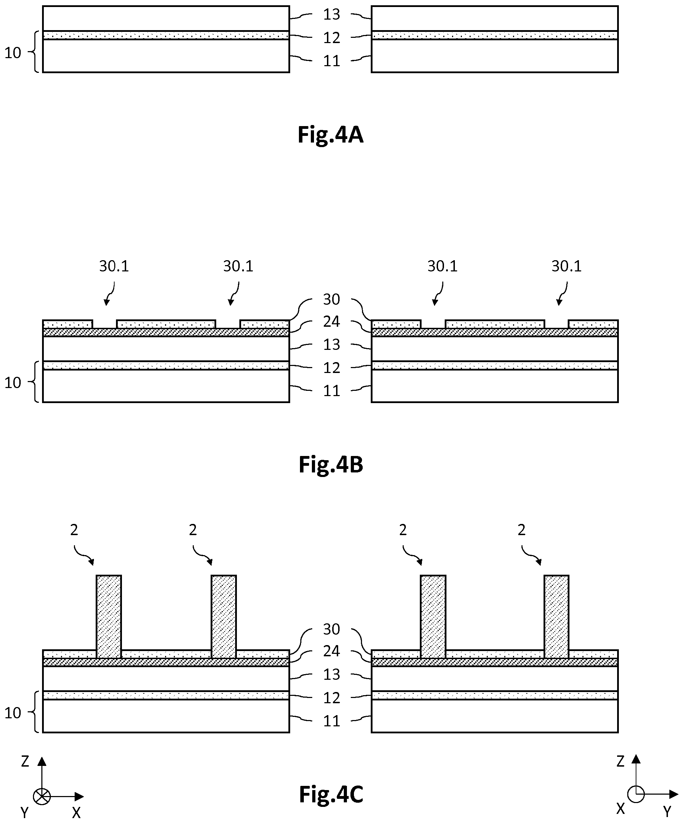

Les figures 4A à 4F illustrent schématiquement et de manière partielle, en coupe transversale, différentes étapes d'un exemple de procédé de fabrication du dispositif optoélectronique 1 selon le premier mode de réalisation décrit précédemment. Chaque figure illustre une vue en coupe selon le plan A-A (gauche) et une vue en coupe selon le plan B-B (droite).

En référence à la figure 4A, on fournit un empilement formé d'un support 10 et d'une couche 13 destinée à former les portions conductrices longitudinales 21, cette couche étant ici une couche semiconductrice dopée 13 selon le premier type de conductivité. Le support 10 est formé d'une couche épaisse 11 et d'une couche isolante inférieure 12. Dans cet exemple, cet empilement est avantageusement un substrat SOI. La couche épaisse 11 est réalisée en silicium, la couche isolante inférieure 12 en SiOₓ et la couche semiconductrice 13 en silicium monocristallin dopé, ici de type n. Le dopage du silicium peut être effectué lors de la fabrication du substrat SOI ou bien être effectué par une ou plusieurs implantations de dopants, ou être effectué lors de la croissance épitaxiale. La couche semiconductrice dopée 13 peut ainsi présenter une épaisseur comprise entre 0,1µm et 10µm environ, par exemple égale à 1µm, et un niveau de dopage compris entre 3.10¹⁷ at/cm³ et 5.10¹⁹ at/cm³.

En référence à la figure 4B, on dépose une couche conductrice de nucléation 24, destinée à former ultérieurement les bandes conductrices de nucléation 22. La couche conductrice de nucléation 24 peut être déposée par croissance épitaxiale de manière à recouvrir uniformément la surface supérieure de la couche semiconductrice dopée 13. Elle est réalisée en au moins un matériau permettant la nucléation ultérieure des premières portions dopées 40 des diodes 2, de préférence en un matériau à base d'un métal de transition, par exemple par une technique de pulvérisation cathodique.

Dans cet exemple, on dépose ensuite une première couche isolante intermédiaire 30 formant un masque de croissance. Cependant, en variante, il est possible, au préalable, de structurer la couche conductrice de nucléation 24 par photolithographie et gravure pour former les différentes bandes conductrices de nucléation 22. On dépose ainsi une couche 30 d'un matériau diélectrique, par exemple du SiO ou SiN, de manière à recouvrir la surface supérieure de la couche conductrice de nucléation 24, puis on forme des ouvertures traversantes 30.1 de manière à déboucher localement sur des surfaces de nucléation. De préférence, les dimensions latérales des ouvertures traversantes 30.1 sont inférieures à la largeur de ce que seront les bandes conductrices de nucléation 22, par exemple au moins deux fois inférieures. En variante, il est possible de réaliser les portions conductrices longitudinales 21 et les bandes conductrices de nucléation 22 par photolithographie et gravure, avant l'étape de dépôt de la couche isolante intermédiaire 30.

En référence à la figure 4C, on forme les premières portions dopées 40, ici réalisés en GaN, par croissance épitaxiale à partir des surfaces de nucléation des différentes bandes conductrices de nucléation 22, au travers des ouvertures 30.1 du masque de croissance 30. Dans cet exemple, les diodes 2 sont réalisées avant la formation des tranchées d'isolation 5 mais, en variante, elles pourraient être réalisées après la formation de ces tranchées.

La technique d'épitaxie peut être un procédé du type dépôt chimique en phase vapeur (CVD, pour Chemical Vapor Déposition, en anglais), par exemple aux précurseurs organométalliques (MOCVD, pour Metal-Organic Chemical Vapor Déposition, en anglais) ou par un procédé de type épitaxie par jets moléculaires (MBE, pour Molecular-Beam Epitaxy, en anglais), du type épitaxie en phase vapeur aux hydrures (HVPE, pour Hydride

Vapor Phase Epitaxy, en anglais), du type épitaxie par couche atomique (ALE, pour Atomic Layer Epitaxy, en anglais) ou dépôt par couche atomique (ALD, pour Atomic Layer Déposition, en anglais), voire par évaporation ou par pulvérisation cathodique (sputtering, en anglais). De préférence, le procédé d'épitaxie est identique ou similaire à celui décrit dans le document WO 2012/136665 A1. On obtient ainsi des premières portions dopées 40 sous forme de fils qui s'étendent suivant l'axe longitudinal Δ à partir des surfaces de nucléation. Le premier composé semiconducteur des premières portions dopées 40, à savoir ici le GaN, est dopé de type n par du silicium. La partie inférieure 41 des fils 40 est située dans les ouvertures 30.1 de la couche isolante intermédiaire 30, et se prolonge suivant l'axe longitudinal Δ par la partie supérieure 42. Les zones actives formées d'une alternance de couches barrières et de puits quantiques ici en InGaN recouvrent la partie supérieure 42 des fils, et sont recouvertes par la deuxième portion dopée 43, à savoir ici en GaN ou InGaN dopé p. Les secondes portions dopées 43 et les zones actives forment ainsi les coquilles des diodes 2 en configuration cœur/coquille.

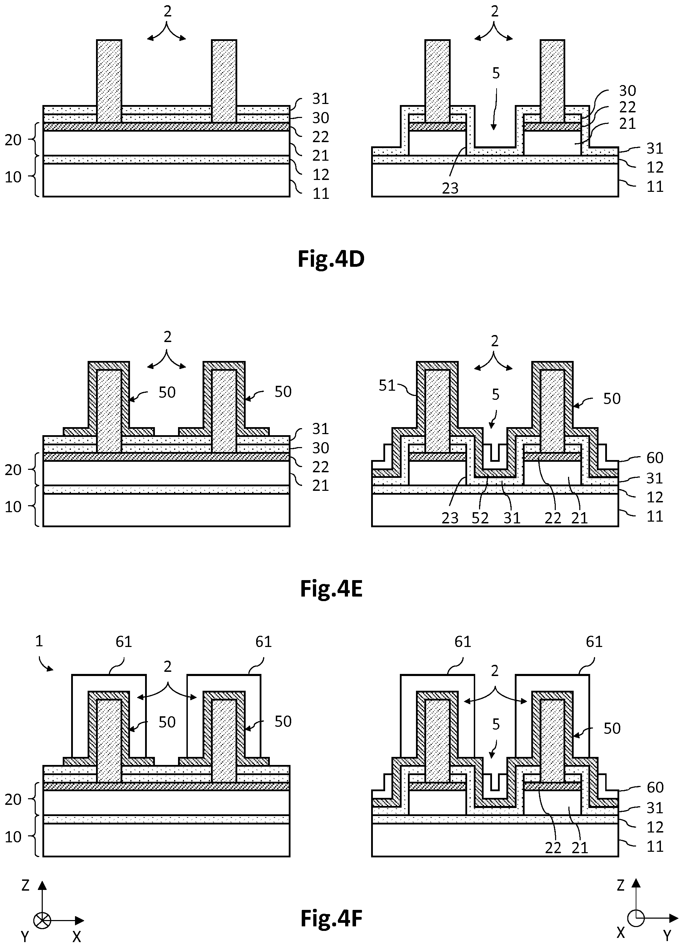

En référence à la fig.4D, on réalise les tranchées d'isolation 5 de manière à former les premières électrodes 20. Pour cela, on réalise des gravures longitudinales localisées de l'empilement formé du masque de croissance 30, de la couche conductrice de nucléation 24 et de la couche semiconductrice dopée 13 jusqu'à déboucher sur la face supérieure de la couche isolante inférieure 12. Cette étape est réalisée par des opérations classiques de photolithographie et de gravure. On obtient ainsi une pluralité de premières électrodes 20 distinctes les unes des autres et électriquement isolées des voisines par les tranchées d'isolation 5. Les premières électrodes 20 s'étendent longitudinalement suivant l'axe A1. Dans cet exemple, les portions conductrices longitudinales 21 et les bandes conductrices de nucléation 22 présentent une même largeur, qui reste constante longitudinalement.

Puis, on dépose une deuxième couche isolante intermédiaire 31 destinée à participer à isoler électriquement les premières électrodes 20 vis-à-vis des deuxièmes électrodes 50. Pour cela, on peut procéder comme décrit dans la demande de brevet WO 2016/108023 A1, c'est-à-dire en déposant une couche isolante de manière conforme sur la totalité de la structure précédemment obtenue, puis en la recouvrant d'une couche de résine photosensible, en gravant partiellement la couche de résine pour exposer au moins en partie la couche isolante recouvrant la seconde portion dopée 43, et en gravant cette partie exposée de la couche isolante. Dans la mesure où les tranchées d'isolation 5 ne sont pas comblées, la deuxième couche isolante intermédiaire 31 recouvre les flancs latéraux 23 des premières électrodes 20 et s'étend ici jusqu'à la couche isolante inférieure 12. Elle peut recouvrir ou non la couche isolante inférieure 12.

En référence à la figure 4E, on forme les deuxièmes électrodes 50, c'est-à-dire les bandes conductrices transparentes 50. Pour cela, on dépose de manière conforme une couche continue d'un matériau conducteur et ici au moins partiellement transparent au rayonnement lumineux émis par les diodes 2. Puis, par photolithographie et gravure, on forme les bandes conductrices transparentes 50 distinctes les unes des autres, s'étendant de manière parallèle à un axe A2. Elles comportent ici chacune des parties qui recouvrent les secondes portions dopées 43 d'un ensemble Dj de diodes 2, ces parties recouvrantes 51 étant reliées longitudinalement deux à deux par des parties de liaison 52 qui s'étendent dans les tranchées d'isolation 5, recouvrant ainsi les flancs latéraux 23 des premières électrodes 20 ainsi que la couche isolante inférieure 12. Les deuxièmes électrodes 50 sont électriquement isolées des premières électrodes 20 au moyen des première et deuxième couches isolantes intermédiaires 30, 31.

De manière avantageuse, on recouvre les parties de liaison 52 des bandes conductrices transparentes 50 par une couche conductrice réfléchissante 60 adaptée à réduire la résistance électrique des bandes conductrices transparentes 50 et à réfléchir le rayonnement incident émis par les diodes 2. Cette couche réfléchissante 60 peut être en un ou plusieurs matériaux choisis parmi l'aluminium, l'argent, l'or ou tout autre matériau adapté, et présente une épaisseur par exemple comprise entre 20nm et 1500nm, de préférence comprise entre 400nm et 800nm. L'épaisseur peut être choisie pour combler le volume libre des tranchées d'isolation 5. Pour cela, on dépose de manière conforme une couche continue conductrice et réfléchissante. Puis par photolithographie et gravure, on forme les bandes conductrices et réfléchissantes 60 distinctes les unes des autres, s'étendant de manière parallèle à un axe A2.

En référence à la figure 4F on réalise les plots 61 de conversion de couleur, à raison de préférence d'un plot par pixel. La réalisation des plots de conversion 61 peut être effectuée par des techniques classiques dites additives (par ex. jet d'encre) ou par des techniques dites soustractives (dépôt d'une dispersion colloïdale ou d'une résine photosensible comprenant des éléments de conversion de couleurs puis formation des plots par photolithographie ou ablation laser).

On procède ensuite à la réalisation des premiers plots 3 et des deuxièmes plots 4 de connexion (non représentés). Dans le cas où ces plots 3, 4 sont réalisés en face arrière du support 10, on peut effectuer un amincissement de la couche épaisse 11, puis on réalise des orifices traversants débouchant au niveau des premières électrodes 20 et au niveau des deuxièmes électrodes 50. Les flancs des orifices traversants peuvent être revêtus d'une couche isolante, puis un matériau conducteur remplit l'intérieur des orifices traversants. Les premiers et deuxièmes plots de connexion 4 sont ensuite formés.

Le procédé de réalisation du dispositif optoélectronique 1 présente l'avantage de former des pixels Pᵢⱼ de diodes 2 au moyen des premières et deuxièmes électrodes 20, 50 positionnées en face avant du support 10, qui se présentent sous la forme de bandes conductrices distinctes les unes des autres. Ainsi, le support 10 présente une tenue mécanique améliorée, ce qui facilite notamment l'hybridation au circuit de commande. De plus, les diodes 2 présentent des propriétés optiques et/ou électroniques préservées dans la mesure où la pixellisation des diodes 2 ne requiert pas, comme dans l'exemple de l'art antérieur mentionné précédemment, une gravure des portions dopées et de la zone active. Les propriétés électriques du dispositif optoélectronique 1 sont améliorées par la formation des premières électrodes 20 sous la forme d'un empilement d'une portion conductrice longitudinale 21 à faible résistance électrique et d'une bande conductrice de nucléation 22.

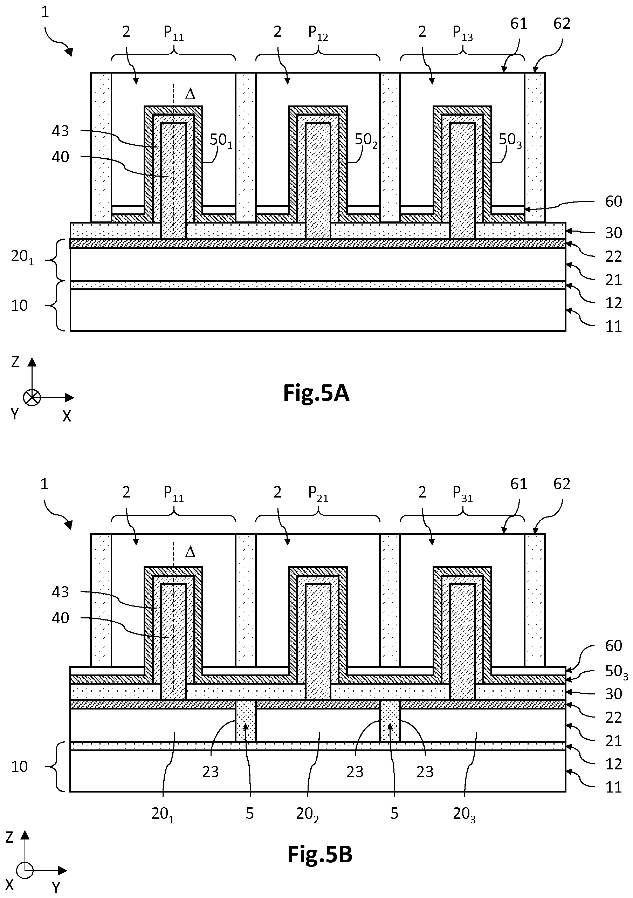

Les figures 5A et 5B sont des vues schématiques et partielles, en coupe respectivement selon le plan A-A et B-B, d'un dispositif optoélectronique 1 selon un deuxième mode de réalisation.

Le dispositif optoélectronique 1 selon le deuxième mode de réalisation diffère de celui illustré sur les fig.3A et 3B notamment en ce que les tranchées d'isolation 5 sont comblées par un matériau diélectrique, de manière à former une surface plane avec la face supérieure des bandes conductrices de nucléation 22. Ainsi, la première couche isolante intermédiaire 30 (masque de croissance) s'étend continûment de manière plane.

Les premières électrodes 20 sont électriquement isolées des voisines par des tranchées d'isolation 5, par exemple de type STI (pour *Shallow Trench Isolation,* en anglais) qui s'étendent le long des flancs latéraux 23 des premières électrodes 20 jusqu'à la couche isolante inférieure 12.

Le masque de croissance 30 est revêtu localement par les bandes conductrices transparentes 50. Il assure ainsi l'isolation électrique entre les premières et les deuxièmes électrodes 20, 50. La deuxième couche isolante intermédiaire 31 n'est pas nécessaire, dans la mesure où les bandes conductrices transparentes 50 ne descendent pas dans les tranchées d'isolation 5.

Ce mode de réalisation permet d'obtenir des tranchées d'isolation 5 de plus petite largeur, et permettant ainsi d'augmenter la résolution du dispositif optoélectronique 1. A titre d'exemple, les tranchées d'isolation 5 peuvent présenter une largeur comprise entre 0,15µm et 10µm, par exemple égale à 1µm. La largeur des tranchées d'isolation 5 correspond à la distance séparant les flancs latéraux 23 se faisant face des premières électrodes 20 adjacentes.

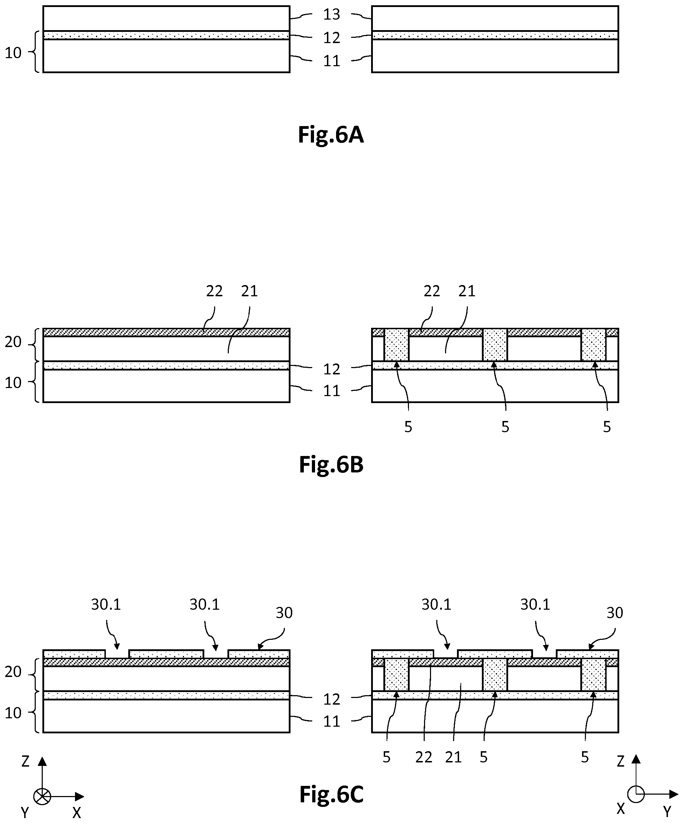

Les figures 6A à 6F illustrent schématiquement et de manière partielle, en coupe transversale, différentes étapes d'un exemple de procédé de fabrication du dispositif optoélectronique 1 selon le deuxième mode de réalisation décrit précédemment.

L'étape de la fig.6A est identique à celle décrite précédemment en référence à la fig.4A.

En référence à la fig.6B, on dépose une couche conductrice de nucléation 24, de manière similaire ou identique au dépôt décrit précédemment (fig.4B), et on réalise des tranchées d'isolation 5 de type STI. Pour cela, on réalise une gravure localisée longitudinale de la couche conductrice de nucléation 24 et de la couche semiconductrice dopée 13, puis on remplit les tranchées d'isolation 5 d'un matériau diélectrique, par exemple un oxyde de silicium. Une planarisation par polissage mécanochimique (CMP) est ensuite effectuée. On obtient ainsi une surface plane formée de la face supérieure des bandes conductrices de nucléation 22 et de la face supérieure du matériau diélectrique de remplissage. En variante, il est possible de réaliser tout d'abord les tranchées d'isolation 5 dans la couche semiconductrice dopée 13, puis on réalise le dépôt structuré de la couche conductrice de nucléation 24 pour obtenir les bandes conductrices de nucléation 22.

En référence à la fig.6C, on réalise le masque de croissance 30. Pour cela, on dépose la couche isolante intermédiaire sur la surface plane, puis on forme les ouvertures traversantes 30.1 débouchant sur les surfaces de nucléation. La couche isolante intermédiaire 30 s'étend ainsi de manière plane dans le plan XY et ne s'étend pas dans les tranchées d'isolation 5.

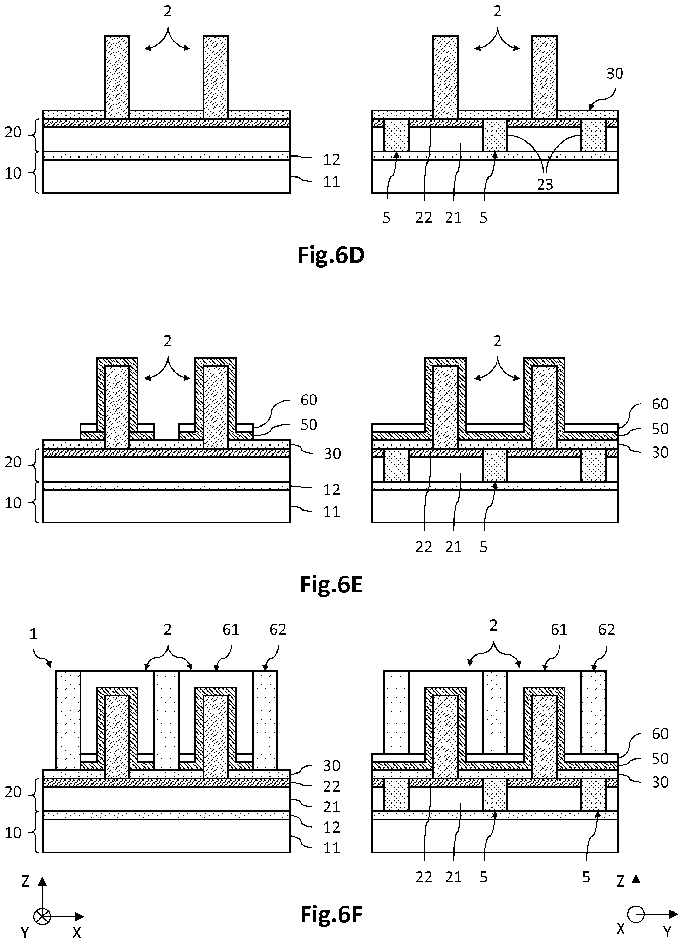

En référence à la fig.6D, on réalise les diodes 2. Cette étape est identique à celle décrite précédemment en référence à la fig.4D.

En référence à la fig.6E, on réalise les secondes électrodes 50 sous forme de bandes conductrices transparentes. Pour cela, on dépose une couche conductrice transparente que l'on structure par photolithographie et gravure pour former les bandes 50. Les parties de liaison 52 s'étendent ici de manière plane sur le masque de croissance 30 et ne descendent pas dans les tranchées d'isolation 5. Une couche conductrice réfléchissante 60 est ensuite formée sur les parties de liaison 52 des bandes conductrices transparentes 50 pour améliorer la conduction électrique et permettre la réflexion optique du rayonnement lumineux incident.

En référence à la fig.6F, on réalise les plots 61 de conversion de couleur. Dans cet exemple, une couche d'encapsulation 62 s'étend entre les plots de conversion 61.

Il est avantageux que les tranchées d'isolation 5 de type STI soient réalisées avant la formation des diodes 2, de manière à obtenir un pas d'espacement des pixels particulièrement faible et donc un dispositif optoélectronique à haute résolution.

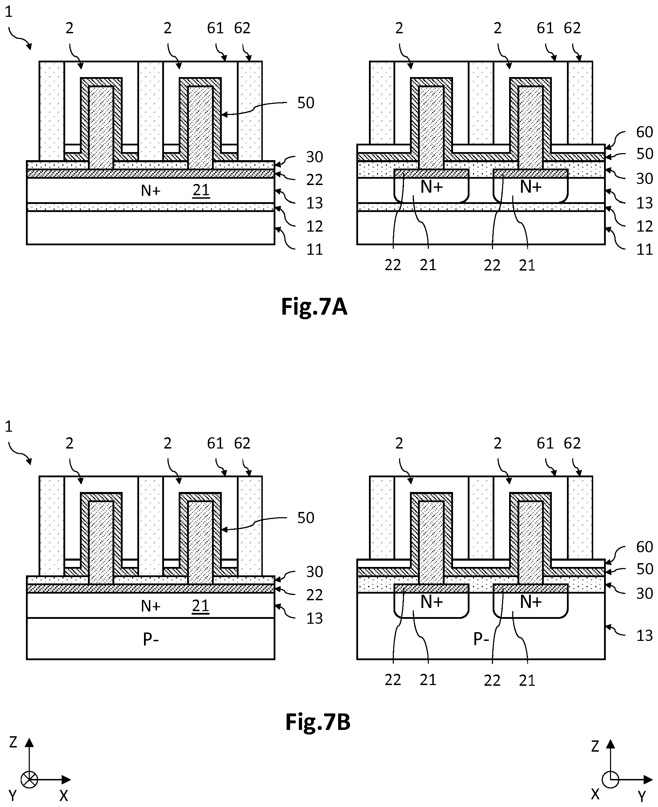

Les figures 7A et 7B sont des vues schématiques et partielles, en coupe selon le plan A-A et B-B, de deux variantes d'un dispositif optoélectronique 1 selon un troisième mode de réalisation.

Le dispositif optoélectronique 1 selon le troisième mode de réalisation diffère de ceux illustrés sur les fig.3A-3B et 5A-5B essentiellement en ce que les portions conductrices longitudinales 21 sont formées à l'intérieur d'une couche semiconductrice 13 du support 10 à partir d'une face supérieure de celui-ci, et sont électriquement isolées les unes des autres par jonctions pn polarisées en inverse (déplétion). Autrement dit, chaque portion conductrice longitudinale 21 est formée d'un caisson longitudinal, c'est-à-dire d'une zone 21 dopée selon le premier type de conductivité (identique à celui des premières portions dopées 40 des diodes 2) de la couche semiconductrice 13 dopée selon le deuxième type de conductivité.

A titre d'exemple, en référence à la fig.7A, le support 10 est formé ici d'un empilement d'une couche épaisse 11, d'une couche isolante inférieure 12 et d'une couche semiconductrice 13. Cette couche semiconductrice 13 peut être faiblement dopée et présente une conductivité de type de p, et les portions conductrices longitudinales 21 sont formées par des caissons fortement dopés de type n. Chaque caisson s'étend à partir de la surface supérieure de la couche semiconductrice 13 sur laquelle repose les bandes conductrices de nucléation 22, ici jusqu'à la couche isolante inférieure 12. La couche épaisse 11 est électriquement isolée des caissons par la couche isolante inférieure 12 et peut présenter un dopage de type n ou p, voire être intrinsèque (non intentionnellement dopé).

En référence à la fig.7B, le support 10 ne comporte pas de couche épaisse 11 ni de couche isolante inférieure 12 et est formé de la seule couche semiconductrice 13. Comme précédemment, la couche semiconductrice 13 est ici faiblement dopée de type p, et les portions conductrices longitudinales 21 sont formées par des caissons fortement dopés de type n. Chaque caisson 21 s'étend à partir de la surface supérieure de la couche semiconductrice 13 sur laquelle repose les bandes conductrices de nucléation 22.

Les caissons 21 qui forment les portions conductrices longitudinales peuvent être obtenus par implantation ionique avant la réalisation des bandes conductrices de nucléation 22. Comme dans le deuxième mode de réalisation, le masque de croissance 30 s'étend de manière plane sur la couche semiconductrice 13 comportant les portions conductrices longitudinales 21, et sur les bandes conductrices de nucléation 22. Il assure l'isolation électrique entre les premières et les deuxièmes électrodes 20, 50.

Des modes de réalisation particuliers viennent d'être décrits. Différentes variantes et modifications apparaîtront à l'homme du métier, notamment en termes de type de conductivité des caissons formant les portions conductrices longitudinales 21 et de la couche semiconductrice, ainsi qu'en termes de niveau de dopage.

Par ailleurs, des caractéristiques d'un mode de réalisation peuvent être présentes dans d'autres modes de réalisation. Ainsi, en référence à la fig.3B, des plots d'un matériau électriquement isolant, par exemple un oxyde ou nitrure de silicium, peuvent être au contact des flancs latéraux 23 des premières électrodes 20, améliorant ainsi l'isolation électrique entre les premières et deuxièmes électrodes 20, 50.

Les diodes électroluminescentes décrites précédemment sont en configuration dite cœur/coquille. Elles peuvent en variante présenter une configuration axiale dans laquelle la seconde portion dopée 43 ne recouvre que l'extrémité axiale de la première portion dopée 40, entre lesquelles est située la zone active. La deuxième couche isolante intermédiaire 31 (fig.3B) ou la première couche isolante intermédiaire (fig.5A-5B ; fig.7A-7B) présente alors une épaisseur telle que les bandes conductrices transparentes 50 ne recouvrent que les secondes portions dopées 43 sans revêtir latéralement les premières portions dopées 40.

## Revendications

1. Dispositif optoélectronique (1), comportant :
- un support (10) ;
- une pluralité de premières électrodes (20) distinctes, s'étendant longitudinalement au contact du support (10), parallèlement à un axe A1, chaque première électrode (20) étant formée d'un empilement d'une portion conductrice longitudinale (21) située au contact du support (10) et revêtue d'une bande conductrice de nucléation (22), la portion conductrice longitudinale (21) présentant une résistance électrique inférieure de celle de la bande conductrice de nucléation (22) ;
- une pluralité de diodes (2) comportant chacune une première portion (40) tridimensionnelle dopée selon un premier type de conductivité et une deuxième portion dopée (43) selon un deuxième type de conductivité opposé au premier type, les premières portions dopées (40) étant au contact des bandes conductrices de nucléation (22), agencées de sorte que chaque bande conductrice de nucléation (22) est au contact de plusieurs premières portions dopées (40) disposées longitudinalement ;
- au moins une couche isolante intermédiaire (30,31) recouvrant les premières électrodes (20) ;
- une pluralité de deuxièmes électrodes (50) distinctes, sous forme de bandes conductrices transparentes, s'étendant longitudinalement au contact des deuxièmes portions dopées (43), électriquement isolées des premières électrodes (20) au moyen de la couche isolante intermédiaire (30, 31), parallèlement à un axe A2, l'axe A2 étant non parallèle à l'axe A1, de sorte qu'une même bande conductrice transparente (50) est au contact de secondes portions dopées (43) d'un ensemble de diodes (2) dont les premières portions dopées (40) sont au contact de différentes bandes conductrices de nucléation (22).

2. Dispositif optoélectronique (1) selon la revendication 1, dans lequel les portions conductrices longitudinales (21) présentent une épaisseur prédéterminée et sont réalisées en un matériau semiconducteur dopé selon le premier type de conductivité, le niveau de dopage et l'épaisseur étant adaptés de sorte qu'un rapport résistivité électrique sur épaisseur des portions conductrices longitudinales (21) est inférieur à celui des bandes conductrices de nucléation (22).

3. Dispositif optoélectronique (1) selon la revendication 1 ou 2, dans lequel les premières électrodes (20) sont isolées transversalement les unes des autres par des tranchées d'isolation (5).

4. Dispositif optoélectronique (1) selon la revendication 3, dans lequel chaque première électrode (20) repose sur une couche isolante inférieure (12) et présente des flancs latéraux (23) qui s'étendent jusqu'à la couche isolante inférieure (12), la couche isolante intermédiaire (31) s'étendant de manière à recouvrir les bandes conductrices de nucléation (22) ainsi que les flancs latéraux (23).

5. Dispositif optoélectronique (1) selon la revendication 4, dans lequel les bandes conductrices transparentes (50) s'étendent de manière à recouvrir les bandes conductrices de nucléation (22), les flancs latéraux (23) et la couche isolante inférieure (12), et sont électriquement isolées des flancs latéraux (23) par la couche isolante intermédiaire (31).

6. Dispositif optoélectronique (1) selon la revendication 3, dans lequel chaque tranchée d'isolation (5) est comblée par un matériau isolant formant avec les bandes conductrices de nucléation (22) une surface plane.

7. Dispositif optoélectronique (1) selon la revendication 6, dans lequel les tranchées d'isolation (5) présentent une largeur comprise entre 0,15µm et 10µm.

8. Dispositif optoélectronique (1) selon la revendication 1 ou 2, dans lequel le support (10) comporte une couche semiconductrice dopée (13) selon le deuxième type de conductivité, les portions conductrices longitudinales (21) étant formés dans la couche semiconductrice dopée (13) sous la forme de caissons longitudinaux distincts les uns des autres dopés selon le premier type de conductivité.

9. Dispositif optoélectronique (1) selon l'une quelconque des revendications 6 à 8, dans lequel la couche isolante intermédiaire (30) s'étend de manière plane et recouvre les premières électrodes (20) en étant au contact des bandes conductrices de nucléation (22).

10. Dispositif optoélectronique (1) selon l'une quelconque des revendications 1 à 9, dans lequel chaque bande conductrice transparente (50) comporte des parties (51) recouvrant un ensemble de deuxièmes portions dopées (43), lesdites parties recouvrantes (51) étant reliées entre elles par des parties de liaison (52) reposant sur la couche isolante intermédiaire (30, 31).

11. Dispositif optoélectronique (1) selon la revendication 10, dans lequel les parties de liaison (52) sont recouvertes par et au contact d'une couche conductrice réfléchissante (60).

12. Dispositif optoélectronique (1) selon l'une quelconque des revendications 1 à 11, dans lequel le matériau des bandes conductrices de nucléation (22) comporte un métal de transition.

## Patentansprüche

1. Optoelektronische Vorrichtung (1), die Folgendes aufweist:
- einen Träger (10);
- eine Vielzahl von getrennten ersten Elektroden (20), die sich in Längsrichtung in Kontakt mit dem Träger (10) parallel zu einer Achse A₁ erstrecken, wobei jede erste Elektrode (20) aus einem Stapel eines längsgerichteten leitenden Abschnitts (21) gebildet ist, der in Kontakt mit dem Träger (10) angeordnet und mit einem keimbildenden leitenden Streifen (22) beschichtet ist, wobei der längsgerichtete leitende Abschnitt (21) einen geringeren elektrischen Widerstand als der keimbildende leitende Streifen (22) aufweist;
- eine Vielzahl von Dioden (2), die jeweils einen ersten dreidimensionalen Abschnitt (40) aufweisen, der entsprechend einem ersten Leitfähigkeitstyp dotiert ist, und einen zweiten Abschnitt (43), der entsprechend einem zweiten, dem ersten Typ entgegengesetzten Leitfähigkeitstyp dotiert ist, wobei die ersten dotierten Abschnitte (40) in Kontakt mit den keimbildenden leitenden Streifen (22) stehen, die so angeordnet sind, dass jeder keimbildenden leitenden Streifen (22) in Kontakt mit mehreren in Längsrichtung angeordneten ersten dotierten Abschnitten (40) steht;
- mindestens eine isolierende Zwischenschicht (30, 31), die die ersten Elektroden (20) bedeckt;
- eine Vielzahl von getrennten zweiten Elektroden (50) in Form von transparenten leitenden Streifen, die sich in Längsrichtung in Kontakt mit den zweiten dotierten Abschnitten (43) erstrecken und von den ersten Elektroden (20) durch die isolierende Zwischenschicht (30, 31) elektrisch isoliert sind, parallel zu einer Achse A₂, wobei die Achse A₂ nicht parallel zur Achse A₁ verläuft, so dass ein und derselbe transparente leitende Streifen (50) mit zweiten dotierten Abschnitten (43) einer Diodenanordnung (2) in Kontakt ist, deren erste dotierte Abschnitte (40) mit unterschiedlichen keimbildenden leitenden Streifen (22) in Kontakt sind.

2. Optoelektronische Vorrichtung (1) nach Anspruch 1, wobei die längsgerichteten leitenden Abschnitte (21) eine vorbestimmte Dicke aufweisen und aus einem Halbleitermaterial hergestellt sind, das entsprechend dem ersten Leitfähigkeitstyp dotiert ist, wobei der Dotierungsgrad und die Dicke so ausgebildet sind, dass ein Verhältnis von elektrischem Widerstand zur Dicke der längsgerichteten leitenden Abschnitte (21) geringer ist als das der keimbildenden leitenden Streifen (22).

3. Optoelektronische Vorrichtung (1) nach Anspruch 1 oder 2, wobei die ersten Elektroden (20) durch Isolationsgräben (5) quer voneinander isoliert sind.

4. Optoelektronische Vorrichtung (1) nach Anspruch 3, wobei jede erste Elektrode (20) auf einer unteren Isolierschicht (12) aufliegt und Seitenflanken (23) aufweist, die sich bis zur unteren Isolierschicht (12) erstrecken, wobei sich die isolierende Zwischenschicht (31) so erstreckt, dass sie die keimbildenden leitenden Streifen (22) sowie die Seitenflanken (23) bedeckt.

5. Optoelektronische Vorrichtung (1) nach Anspruch 4, wobei sich die transparenten leitenden Streifen (50) so erstrecken, dass sie die keimbildenden leitenden Streifen (22), die Seitenflanken (23) und die untere Isolierschicht (12) bedecken und durch die isolierende Zwischenschicht (31) von den Seitenflanken (23) elektrisch isoliert sind.

6. Optoelektronische Vorrichtung (1) nach Anspruch 3, wobei jeder Isolationsgraben (5) mit einem isolierenden Material gefüllt ist, das mit den keimbildenden leitenden Streifen (22) eine ebene Oberfläche bildet.

7. Optoelektronische Vorrichtung (1) nach Anspruch 6, wobei die Isolationsgräben (5) eine Breite zwischen 0,15 µm und 10 µm aufweisen.

8. Optoelektronische Vorrichtung (1) nach Anspruch 1 oder 2, wobei der Träger (10) eine entsprechend dem zweiten Leitfähigkeitstyp dotierte Halbleiterschicht (13) aufweist, wobei die längsgerichteten leitenden Abschnitte (21) in der dotierten Halbleiterschicht (13) als voneinander getrennte längsgerichteten Kästen ausgebildet sind, die mit dem ersten Leitfähigkeitstyp dotiert sind.

9. Optoelektronische Vorrichtung (1) nach einem der Ansprüche 6 bis 8, wobei sich die isolierende Zwischenschicht (30) in einer Ebene erstreckt und die ersten Elektroden (20) in Kontakt mit den keimbildenden leitenden Streifen (22) bedeckt.

10. Optoelektronische Vorrichtung (1) nach einem der Ansprüche 1 bis 9, wobei jeder transparente leitende Streifen (50) Teile (51) aufweist, die einen Satz der zweiten dotierten Abschnitte (43) bedecken, wobei die bedeckenden Teile (51) durch Verbindungsteile (52), die auf der isolierenden Zwischenschicht (30, 31) ruhen, miteinander verbunden sind.

11. Optoelektronische Vorrichtung (1) nach Anspruch 10, wobei die Verbindungsteile (52) von einer reflektierenden leitfähigen Schicht (60) bedeckt sind und mit dieser in Kontakt stehen.

12. Optoelektronische Vorrichtung (1) nach einem der Ansprüche 1 bis 11, wobei das Material der keimbildenden leitenden Streifen (22) ein Übergangsmetall aufweist.

## Claims

1. Optoelectronic device (1) comprising:
- a carrier (10);
- a plurality of separate first electrodes (20) that extend longitudinally in contact with the carrier (10), parallel to an axis A1, each first electrode (20) being formed of a stack of a longitudinal conductive portion (21) located in contact with the carrier (10) and coated with a conductive nucleation strip (22), the longitudinal conductive portion (21) having an electrical resistance lower than that of the conductive nucleation strip (22);
- a plurality of diodes (2) each comprising a first three-dimensional portion (40) doped according to a first conductivity type and a second portion (43) doped according to a second conductivity type opposite the first type, the first doped portions (40) being in contact with the conductive nucleation strips (22), and being arranged such that each conductive nucleation strip (22) is in contact with a plurality of first doped portions (40) arranged longitudinally;
- at least one intermediate insulating layer (30, 31) covering the first electrodes (20);
- a plurality of separate second electrodes (50) in the form of transparent conductive strips that extend longitudinally in contact with the second doped portions (43), and are electrically insulated from the first electrodes (20) by means of the intermediate insulating layer (30, 31), parallel to an axis A2, the axis A2 not being parallel to the axis A1, such that one and the same transparent conductive strip (50) is in contact with second doped portions (43) of a set of diodes (2), the first doped portions (40) of which are in contact with different conductive nucleation strips (22).

2. Optoelectronic device (1) according to Claim 1, wherein the longitudinal conductive portions (21) have a predetermined thickness and are made of a semiconductor material doped according to the first conductivity type, the doping level and the thickness being adjusted such that an electrical resistivity to thickness ratio of the longitudinal conductive portions (21) is lower than that of the conductive nucleation strips (22).

3. Optoelectronic device (1) according to Claim 1 or 2, wherein the first electrodes (20) are isolated transversely from one another by trench isolations (5).

4. Optoelectronic device (1) according to Claim 3, wherein each first electrode (20) rests on a lower insulating layer (12) and has lateral flanks (23) which extend down to the lower insulating layer (12), the intermediate insulating layer (31) extending so as to cover the conductive nucleation strips (22) and the lateral flanks (23).

5. Optoelectronic device (1) according to Claim 4, wherein the transparent conductive strips (50) extend so as to cover the conductive nucleation strips (22), the lateral flanks (23) and the lower insulating layer (12), and are electrically insulated from the lateral flanks (23) by the intermediate insulating layer (31).

6. Optoelectronic device (1) according to Claim 3, wherein each trench isolation (5) is filled with an insulating material forming, together with the conductive nucleation strips (22), a planar surface.

7. Optoelectronic device (1) according to Claim 6, wherein the trench isolations (5) have a width of between 0.15 µm and 10 µm.

8. Optoelectronic device (1) according to Claim 1 or 2, wherein the carrier (10) comprises a semiconductor layer (13) doped according to the second conductivity type, the longitudinal conductive portions (21) being formed in the doped semiconductor layer (13) in the form of longitudinal wells separate from one another and doped according to the first conductivity type.

9. Optoelectronic device (1) according to any one of Claims 6 to 8, wherein the intermediate insulating layer (30) extends planarly and covers the first electrodes (20) while being in contact with the conductive nucleation strips (22).

10. Optoelectronic device (1) according to any one of Claims 1 to 9, wherein each transparent conductive strip (50) comprises parts (51) covering a set of second doped portions (43), said covering parts (51) being connected to one another by connecting parts (52) resting on the intermediate insulating layer (30, 31).

11. Optoelectronic device (1) according to Claim 10, wherein the connecting parts (52) are covered by and in contact with a reflective conductive layer (60).

12. Optoelectronic device (1) according to any one of Claims 1 to 11, wherein the material of the conductive nucleation strips (22) comprises a transition metal.
